# EUROPEAN PATENT APPLICATION

(11) **EP 4 618 086 A1**
(43) Date of publication of application: **17.09.2025**
(21) Application number: 24883637.1
(22) Date of filing: 19.09.2024
(51) Int. Cl.: G11C 11/406, G11C 11/408

(54) **MEMORY STRUCTURE, REFRESHING METHOD, AND MEMORY**

(30) Priority: 01.02.2024 CN 202410139681
(71) Applicant: CXMT Corporation, Hefei, Anhui 230601 (CN)
(72) Inventor: ZHOU, Runfa, Hefei Anhui 230601 (CN)
(74) Representative: Gulde & Partner
(86) International application number: PCT/CN2024/119539
(87) International publication number: WO 2025/161423

(57) **Abstract**

A memory structure, a refresh method, and a memory are provided, where the memory structure includes: a refresh address storing circuit, disposed in a memory controller and configured to store supplementary refresh addresses, each of the supplementary refresh addresses being used to indicate a memory cell with a defective capability for storing electric charges; and refresh registers, each of the refresh registers being disposed in each memory block of the plurality of memory blocks; where in a power-on process of the memory structure, the refresh address storing circuit transmits the supplementary refresh address to the corresponding refresh register; and each memory block is configured to: during row hammer refresh, perform refresh of a row hammer address based on a first refresh window and a row hammer refresh flag, or perform refresh of the supplementary refresh address based on a second refresh window and a supplementary refresh flag, where the first refresh window and the second refresh window are allocated based on a row hammer refresh window, and a proportion of the first refresh window to the second refresh window is a first preset value.

## Description

The present application claims priority to Chinese Patent Application No. 202410139681.3, filed with China National Intellectual Property Administration on February 01, 2024 and entitled "MEMORY STRUCTURE, REFRESH METHOD, AND MEMORY". The disclosure of the above-referenced application is hereby incorporated by reference in its entirety.

### TECHNICAL FIELD

The present disclosure relates to the field of semiconductor circuit designs, and in particular, to a memory structure, a refresh method, and a memory.

### BACKGROUND

Memories are memory components for storing programs and various types of data information. The memories may be classified into volatile memory apparatuses and non-volatile memory apparatuses. For a dynamic random access memory (DRAM) in the volatile memory apparatuses, the DRAM stores data by charging or discharging capacitors in memory cells, and loses the stored data when power is off. While for the non-volatile memory apparatuses, stored data may also be retained when power is off.

The problem of memory cell failure inevitably occurs in the manufacturing process of the DRAM, and the problem of memory cell failure becomes more serious with miniaturization of the process. For example, the number of weak cells in the DRAM increases, where weak cells are memory cells in which retention time shortensdue to the leakage problem of the memory cells.

Repair of the weak cells is crucial to performance improvement of the DRAM.

### SUMMARY

Embodiments of the present disclosure provide a memory structure, a refresh method, and a memory, to avoid negative effects brought by repair of weak cells.

An embodiment of the present disclosure provides a memory structure, where the memory structure includes a memory controller and a plurality of memory blocks, and the memory structure includes: a refresh address storing circuit, disposed in the memory controller and configured to store supplementary refresh addresses, each of the supplementary refresh addresses being used to indicate a memory cell with a defective capability for storing electric charges; and refresh registers, each of the refresh registers being disposed in each memory block of the plurality of memory blocks; where in a power-on process of the memory structure, the refresh address storing circuit transmits the supplementary refresh address to the corresponding refresh register; and each memory block is configured to: during row hammer refresh, perform refresh of a row hammer address based on a first refresh window and a row hammer refresh flag, or perform refresh of the supplementary refresh address based on a second refresh window and a supplementary refresh flag; where the first refresh window and the second refresh window are allocated based on row hammer refresh windows, and a proportion of the first refresh window to the second refresh window is a first preset value.

The memory structure according to this embodiment extends row hammer protection of a memory to perform row hammer protection and refresh of the supplementary refresh address during original row hammer protection. Specifically, in the original row hammer protection, refresh of the row hammer refresh address is performed based on the row hammer refresh windows, and after row hammer protection is extended, the row hammer refresh windows are subdivided into the first refresh window and the second refresh window, where the first refresh window is continuously used for row hammer protection, that is, for performing refresh of the row hammer refresh address, and the second refresh window is used for refresh of the supplementary refresh address, such that the memory can better store data stored in the weak cells, and negative effects brought by repair of the weak cells are avoided.

In some embodiments, the memory controller includes: a first refresh control circuit, configured to generate an identification signal; a second refresh control circuit, configured to generate the row hammer refresh windows and a row hammer refresh signal; and a refresh processing circuit, connecting the first refresh control circuit and the second refresh control circuit, where if the identification signal is invalid, the refresh processing circuit is configured to generate the first refresh window based on the row hammer refresh windows, and generate the row hammer refresh flag based on the row hammer refresh signal; if the identification signal is valid, the refresh processing circuit is configured to perform cycle count based on the row hammer refresh signal to generate a determination value, where when the determination value is valid, the refresh processing circuit is further configured to generate the second refresh window based on the row hammer refresh windows, and generate the supplementary refresh flag based on the row hammer refresh signal; and when the determination value is invalid, the refresh processing circuit is further configured to generate the first refresh window based on the row hammer refresh windows, and generate the row hammer refresh flag based on the row hammer refresh signal; and the determination value is used to configure the first preset value.

In some embodiments, the first refresh control circuit includes: a count processing circuit, configured to perform count based on each refresh command to generate a refresh count value, where the count processing circuit is further configured to generate and output the identification signal when the refresh count value meets a second preset value; and the second preset value is set to be less than or equal to k, where k is a product of a capacity of the corresponding refresh register for storing the supplementary refresh address and the first preset value.

In some embodiments, the refresh processing circuit includes: a counter, configured to generate the determination value; a first AND logic circuit, where a first input terminal is connected to an output terminal of the counter, a second input terminal is configured to receive the row hammer refresh signal, and an output terminal is configured to output the supplementary refresh flag; an inverter, where an input terminal is connected to the output terminal of the first AND logic circuit, and an output terminal is configured to output the row hammer refresh flag; a second AND logic circuit, where a first input terminal is connected to the output terminal of the first AND logic circuit, a second input terminal is configured to receive the row hammer refresh windows, and an output terminal is configured to output the second refresh window; and a third AND logic circuit, where a first input terminal is connected to the output terminal of the inverter, a second input terminal is configured to receive the row hammer refresh windows, and an output terminal is configured to output the first refresh window.

In some embodiments, each memory block includes: a row hammer refresh circuit, configured to perform refresh of the row hammer address based on the first refresh window and the row hammer refresh flag; and a supplementary refresh circuit, configured to perform refresh of the supplementary refresh address based on the second refresh window and the supplementary refresh flag.

In some embodiments, operations of performing refresh of the row hammer address and performing refresh of the supplementary refresh address are cyclically performed in a preset order.

In some embodiments, the refresh address storing circuit is disposed based on an antifuse memory array.

In some embodiments, the refresh address storing circuit transmits the supplementary refresh address to the corresponding refresh register in a broadcast manner.

Another embodiment of the present disclosure further provides a refresh method, applied to the memory structure according to the above embodiment, including: recording the supplementary refresh addresses in the memory controller; transmitting, by the memory controller, the set supplementary refresh addresses to the corresponding memory blocks; acquiring the first refresh window and the row hammer refresh flag, or acquiring the second refresh window and the supplementary refresh flag; and during row hammer refresh, performing refresh of the row hammer address based on the first refresh window and the row hammer refresh flag, or performing refresh of the supplementary refresh address based on the second refresh window and the supplementary refresh flag, where the first refresh window and the second refresh window are allocated based on the row hammer refresh windows, and the proportion of the first refresh window to the second refresh window is the first preset value.

In some embodiments, acquiring the first refresh window and the row hammer refresh flag, or acquiring the second refresh window and the supplementary refresh flag includes: acquiring the identification signal; if the identification signal is invalid, generating the first refresh window based on the row hammer refresh windows, and generating the row hammer refresh flag based on the row hammer refresh signal; if the identification signal is invalid, performing cycle count based on the row hammer refresh signal to generate a determination value, where when the determination value is valid, the second refresh window is generated based on the row hammer refresh windows, and the supplementary refresh flag is generated based on the row hammer refresh signal; and when the determination value is invalid, the first refresh window is generated based on the row hammer refresh windows, and the row hammer refresh flag is generated based on the row hammer refresh signal.

In some embodiments, a method of acquiring the identification signal includes: performing count based on each refresh command to generate a refresh count value; and generating and outputting the identification signal when the refresh count value meets the second preset value, where the second preset value is set to be less than or equal to k, where k is the product of the capacity of the corresponding refresh register for storing the supplementary refresh address and the first preset value.

Yet another embodiment of the present disclosure further provides a memory, which is disposed based on the memory structure according to the above embodiment, to avoid negative effects brought by repair of weak cells.

### BRIEF DESCRIPTION OF DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1 is a schematic structural diagram of a memory structure according to an embodiment of the present disclosure;
FIG. 2 is a schematic diagram of a principle that a refresh control circuit delivers supplementary refresh addresses to refresh registers according to an embodiment of the present disclosure;
FIG. 3 is a schematic diagram of a principle that row hammer refresh windows are divided into first refresh windows and second refresh windows according to an embodiment of the present disclosure;
FIG. 4 is an exemplary schematic diagram of various allocations of first refresh windows and second refresh windows according to an embodiment of the present disclosure;
FIG. 5 is a schematic partial structural diagram of a memory controller according to an embodiment of the present disclosure;
FIG. 6 is a schematic structural diagram of a refresh processing circuit according to an embodiment of the present disclosure;
FIG. 7 is a schematic flowchart of a refresh method according to another embodiment of the present disclosure; and
FIG. 8 is a schematic structural diagram of a memory according to another embodiment of the present disclosure.

### DESCRIPTION OF EMBODIMENTS

It can be learned from the background that the problem of memory cell failure inevitably occurs in the manufacturing process of a DRAM, and the problem of memory cell failure becomes more serious with miniaturization of the process. For example, the number of weak cells in the DRAM increases, where weak cells are memory cells in which retention time shortensdue to the leakage problem of the memory cells.

Specifically, the weak cells may be repaired by using a redundancy address (redundancy WL/BL) in a memory, or by using an overall increase in a refresh rate of the memory, or by merging architectures of two word lines (WL). The weak cells are repaired based on the redundancy addresses. However, the limited number of the redundancy addresses causes the shortage of repair resources in the memory; the overall increase in the refresh rate of the memory increases the overall power consumption of the memory; merging the architectures of two word lines (WL) results in a decrease in the capacity of the memory.

It can be learned that the current means of repairing the weak cells all bring specific negative effects.

An embodiment of the present disclosure provides a memory structure, to avoid negative effects brought by repair of the weak cells.

Those of ordinary skill in the art can understand that in various embodiments of the present disclosure, numerous technical details are set forth to enable readers to better understand the present disclosure. However, the technical solutions claimed by the present disclosure can also be implemented even without these technical details and the various changes and modifications based on the following embodiments. The division of the following embodiments is for the convenience of description and should not constitute any limitation to the specific implementation of the present disclosure. The various embodiments may be combined or referenced with each other as long as there is no contradiction.

The following describes the memory structure according to this embodiment in detail with reference to the accompanying drawings. Details are as follows:

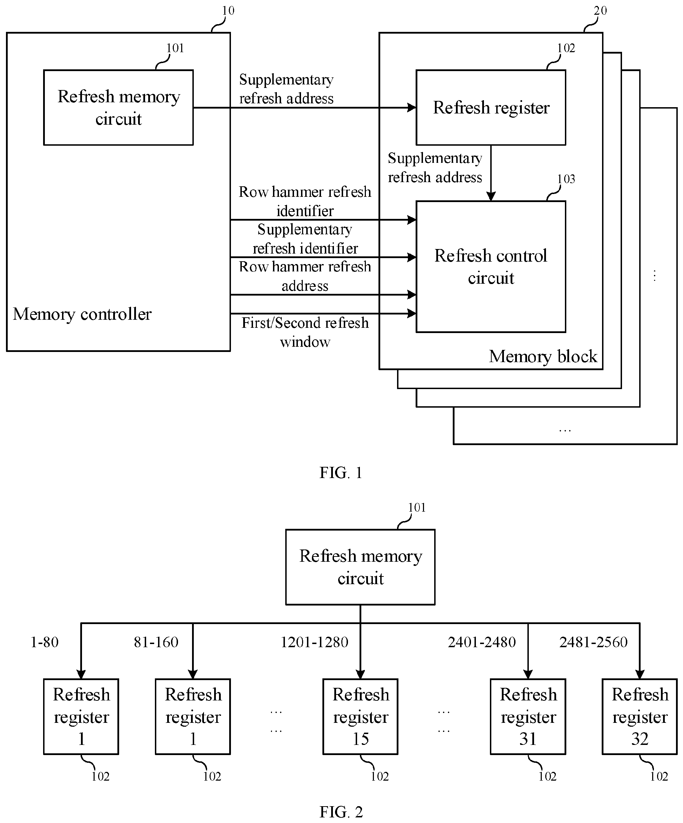

Referring to FIG. 1, which is a schematic structural diagram of a memory structure according to an embodiment of the present disclosure, the memory structure includes a memory controller 10 and a plurality of memory blocks 20, and the memory structure includes a refresh address storing circuit 101 and refresh registers 102.

The refresh address storing circuit 101 is disposed in the memory controller 10 and configured to store supplementary refresh addresses, each of the supplementary refresh addresses being used to indicate a memory cell with a defective capability for storing electric charges. That is, the refresh address storing circuit 101 is configured to store addresses of weak cells. Each of the refresh registers 102 is disposed in each memory block 20 of the plurality of memory blocks 20. In a power-on process of the memory structure, the refresh address storing circuit 101 transmits the supplementary refresh address to the corresponding refresh register 102; and each memory block 20 is configured to: during row hammer refresh, perform refresh of a row hammer address based on a first refresh window and a row hammer refresh flag, or perform refresh of the supplementary refresh address based on a second refresh window and a supplementary refresh flag, where the first refresh window and the second refresh window are allocated based on a row hammer refresh window, and a proportion of the first refresh window to the second refresh window is a first preset value.

Specifically, the supplementary refresh address stored in the refresh address storing circuit 101 is acquired by the memory in a test stage, and in the power-on process of the memory, the refresh address storing circuit 101 correspondingly transmits the stored supplementary refresh address to the refresh register 102 of the corresponding memory block 20. For example, referring to FIG. 2, which is a schematic diagram of a principle that a refresh control circuit delivers supplementary refresh addresses to refresh registers according to an embodiment of the present disclosure, it is assumed that a memory structure includes 32 memory blocks, where a refresh register 1 is disposed in a memory block 1, a refresh register 2 is disposed in a memory block 2, ..., and a refresh register 32 is disposed in a memory block 32. 2560 supplementary refresh addresses are stored in a refresh address storing circuit 101, and in a power-on process of the memory structure, the refresh address storing circuit 101 delivers supplementary refresh addresses 1 to 80 to the memory block 1, where the refresh register 1 is configured to store the supplementary refresh addresses 1 to 80, ..., the refresh address storing circuit 101 delivers supplementary refresh addresses 80n-79 to 80n to a memory block n, where a refresh register n is configured to store the supplementary refresh addresses 80n-79 to 80n, ..., and the refresh address storing circuit 101 delivers supplementary refresh addresses 2481 to 2560 to the memory block 32, where the refresh register 32 is configured to store the supplementary refresh addresses 2481 to 2560.

In some embodiments, the refresh address storing circuit 101 is disposed based on an antifuse memory array. Specifically, the memory fuses a corresponding memory cell in the antifuse memory array based on an address of the weak memory cell acquired in the test stage, such that the refresh address storing circuit 101 stores the supplementary refresh address; the refresh address storing circuit 101 disposed based on the antifuse memory array can retain the set supplementary refresh address in a relatively complete manner even if the power of the memory structure is down. In other embodiments, the refresh address storing circuit may also store the supplementary refresh address based on a register or based on capacitive storage.

In some embodiments, the refresh address storing circuit 101 transmits the supplementary refresh address to the corresponding refresh register 102 in a broadcast manner. Specifically, in the power-on process of the memory, the refresh address storing circuit 101 correspondingly transmits the stored supplementary refresh address to the refresh register 102 of the corresponding memory block 20 in a broadcast manner, to increase a delivering speed of the supplementary refresh address. In other embodiments, the refresh address storing circuit may also be configured to correspondingly transmit the supplementary refresh address to the refresh register of the corresponding memory block based on a corresponding control signal in the power-on process of the memory structure.

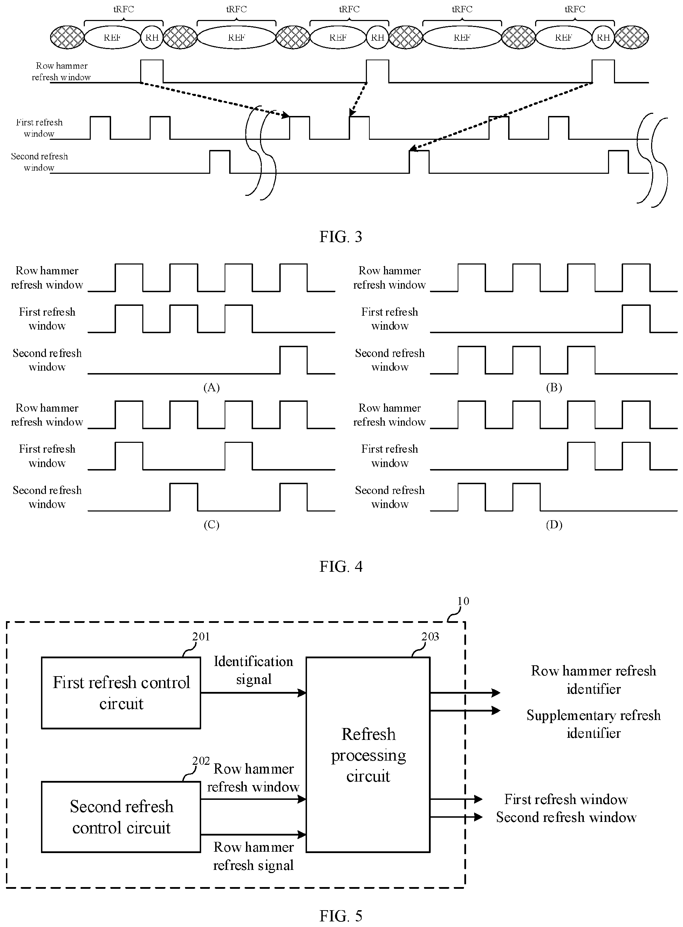

With respect to a relationship among the row hammer refresh windows, the first refresh windows, and the second refresh windows, referring to FIG. 3 and FIG. 4, FIG. 3 is a schematic diagram of a principle that row hammer refresh windows are divided into first refresh windows and second refresh windows according to an embodiment of the present disclosure, and FIG. 4 is an exemplary schematic diagram of various allocations of first refresh windows and second refresh windows according to an embodiment of the present disclosure. In a process of performing a refresh-all-bank (REFab) operation by a memory, a plurality of tRFCs (refresh cycle times) are included, and row hammer protection is performed once every two tRFCs. When the memory needs to perform the row hammer protection, the memory controller provides corresponding row hammer refresh windows. This embodiment is used to allocate the row hammer refresh windows as the first refresh windows and the second refresh windows according to a first preset value.

In one example, if the first preset value is 3:1, referring to FIG. 4(A), every four row hammer refresh windows are allocated as three first refresh windows and one second refresh window; if the first preset value is 1:3, referring to FIG. 4(B), every four row hammer refresh windows are allocated as one first refresh window and three second refresh windows; if the first preset value is 2:2, referring to FIG. 4(C) and FIG. 4(D), every four row hammer refresh windows are allocated as two first refresh windows and two second refresh windows.

Specifically, setting of the first preset value is required to meet a row hammer protection condition and a weak protection condition. For the row hammer protection condition, the total number of row activations A in two adjacent times of row hammer protection is limited to not exceed n1, i.e., A < n1, and the total number of row activations A = n × (tREFI-tRFC)/tRC in the memory, where n represents the number of tREFIs passed, tREFI represents refresh command interval time, and tRC represents time for single address activation. A configuration of the first preset value needs to meet n. For the weak protection condition, the time length of two times of refresh of the same weak cell is limited to not exceed a minimum value of the retention time, and g is the number of tREFIs passed, i.e., g × tREFI < retention time. A configuration of the first preset value needs to meet g.

In one example, under DDR5 16G condition, tREFI = 3.9 µs, tRFC = 295 ns, and tRC = 48 ns. In this case, n < 53, i.e., row hammer protection may not be performed in 52 consecutive tREFIs at most; if the minimum value of the retention time under a certain process condition is 16 ms, g < 4102, i.e., weak protection may not be configured in 4102 consecutive tRFEIs at most, to comprehensively configure the first preset value.

In some embodiments, operations of performing refresh of the row hammer address and performing refresh of the supplementary refresh address are cyclically performed in a preset order. Referring to FIG. 4(C) and FIG. 4(D), if the first preset value is 2:2, every four row hammer refresh windows are allocated as two first refresh windows and two second refresh windows. In this case, a first refresh window and a second refresh window may be configured to be alternately performed singly or two by two.

It should be noted that the description of a specific value of the first preset value in this embodiment is only used for those skilled in the art to understand how to allocate the row hammer refresh windows as the first refresh windows and the second refresh windows, and does not constitute a limitation on the first preset value. During specific application, those skilled in the art may configure the first preset value based on the row hammer protection condition and the weak protection condition independently.

The memory structure according to this embodiment extends row hammer protection of a memory to perform row hammer protection and refresh of the supplementary refresh address during original row hammer protection. Specifically, in the original row hammer protection, refresh of the row hammer refresh address is performed based on the row hammer refresh windows, and after row hammer protection is extended, the row hammer refresh windows are subdivided into the first refresh window and the second refresh window, where the first refresh window is continuously used for row hammer protection, that is, for performing refresh of the row hammer refresh address, and the second refresh window is used for refresh of the supplementary refresh address, such that the memory can better store data stored in the weak cells, and negative effects brought by repair of the weak cells are avoided.

In some embodiments, referring to FIG. 5, which is a schematic partial structural diagram of a memory controller according to an embodiment of the present disclosure, the memory controller includes a first refresh control circuit 201, a second refresh control circuit 202, and a refresh processing circuit 203. The first refresh control circuit 201 is configured to generate an identification signal, and the second refresh control circuit 202 is configured to generate a row hammer refresh window and a row hammer refresh signal. The refresh processing circuit 203 connects the first refresh control circuit 201 and the second refresh control circuit 202.

Specifically, if the identification signal is invalid, the refresh processing circuit 203 is configured to generate a first refresh window based on the row hammer refresh window, and generate a row hammer refresh flag based on the row hammer refresh signal. If the identification signal is valid, the refresh processing circuit 203 is configured to perform cycle count based on the row hammer refresh signal to generate a determination value, where when the determination value is valid, the refresh processing circuit 203 is configured to generate a second refresh window based on the row hammer refresh window, and generate a supplementary refresh flag based on the row hammer refresh signal; when the determination value is invalid, the refresh processing circuit 203 is configured to generate the first refresh window based on the row hammer refresh window, and generate a row hammer refresh flag based on the row hammer refresh signal. The determination value is used to configure a first preset value.

Specifically, because the identification signal represents the start time of a supplementary refresh address, only when the identification signal is valid, a memory structure allocates the row hammer refresh windows to implement the refresh of the supplementary refresh address. In one example, the identification signal is valid when the identification signal is at a high level and is invalid when the identification signal is at a low level. In another example, it may also be configured that the identification signal is valid when the identification signal is at a low level and is invalid when the identification signal is at a high level.

For performing cycle count based on the row hammer refresh signal to generate the determination value, the principle that the determination value is used to configure the first preset value is as follows: Assuming that a row hammer refresh signal cycle count value is a1, that is, count of +1 starts from 0 based on each row hammer refresh signal, upon count to a1, reset is performed to restart the count, and when the count value meets a2, a3, ..., and ai, a valid determination value is generated. In this case, in a1 values, determination values generated by using a1-i values are invalid, and determination values generated by using i values are valid, that is, the first preset value is a1-i:i. In one example, the determination value is valid when the determination value is at a high level and is invalid when the determination value is at a low level. In another example, it may also be configured that the determination value is valid when the determination value is at a low level and is invalid when the determination value is at a high level.

In a specific example, the cycle count value is 5, when the count value meets 2 and 3, a valid determination value is generated. In this case, determination values generated by using three values are invalid, determination values generated by using two values are valid, and the first preset value is 3:2. In addition, refresh of the row hammer address and the supplementary refresh address is cyclically performed in an order of "row hammer-supplementary-supplementary-row hammer-row hammer".

In some embodiments, the first refresh control circuit 201 includes: a count processing circuit, configured to perform count based on each refresh command to generate a refresh count value, where the count processing circuit is further configured to generate and output the identification signal when the refresh count value meets a second preset value. A time period for performing refresh of the supplementary refresh address during refresh-all-bank operation of the memory is set depending on whether the refresh count value meets the second preset value. In one example, refresh of the supplementary refresh address is performed in the initial phase of the refresh-all-bank operation. In this case, the second preset value is set to be equal to or less than k, where k is a product of a capacity of a corresponding refresh register 102 for storing the supplementary refresh address and the first preset value. For example, the capacity of the refresh register 102 for storing the supplementary refresh address is 80, and the first preset value is used to represent that one second refresh window is used to refresh the supplementary refresh address in every three row hammer refresh windows. In this case, 240 row hammer refresh windows are required to complete the refresh of all the supplementary refresh addresses, and two refresh commands in the memory in this embodiment correspond to one row hammer refresh window, that is, k is set to 240 × 2 = 480. In another example, refresh of the supplementary refresh address is performed in the intermediate phase of the refresh-all-banks operation. In yet another example, the refresh of the supplementary refresh address is performed at the end phase of the refresh-all-bank operation.

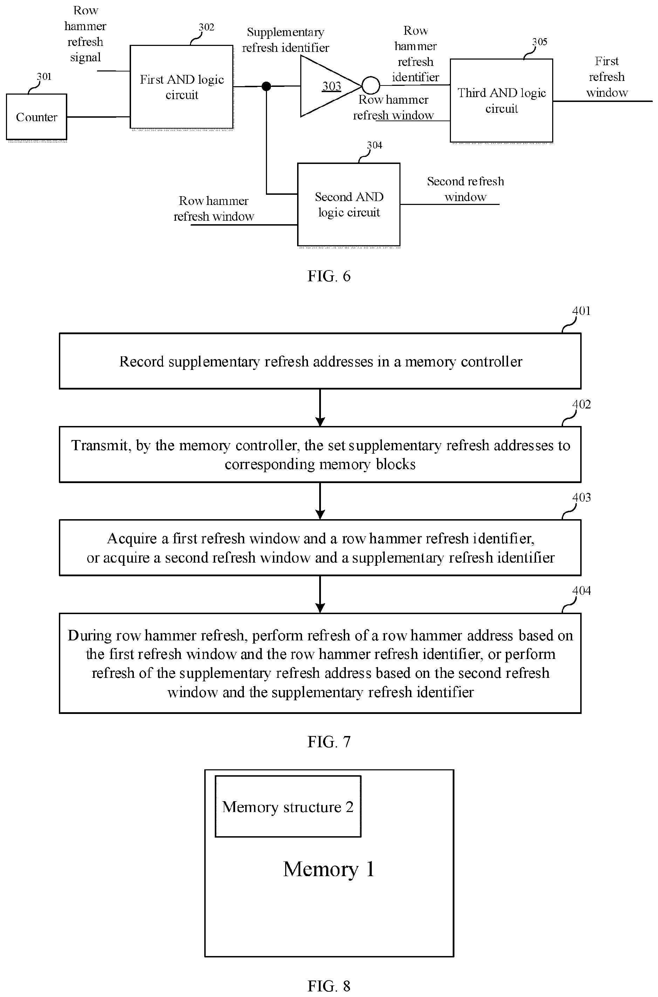

In some embodiments, referring to FIG. 6, which is a schematic structural diagram of a refresh processing circuit according to an embodiment of the present disclosure, the refresh processing circuit 203 includes: a counter 301, configured to generate a determination value; a first AND logic circuit 302, where a first input terminal is connected to an output terminal of the counter 301, a second input terminal is configured to receive a row hammer refresh signal, and an output terminal is configured to output a supplementary refresh flag; an inverter 303, where an input terminal is connected to the output terminal of the first AND logic circuit 302, and an output terminal is configured to output a row hammer refresh flag, where specifically, if the determination value is valid, the refresh processing circuit 203 generates the supplementary refresh flag based on the row hammer refresh signal, and when the supplementary refresh flag is not generated, the inverter 303 connected to the first AND logic circuit 302 generates the row hammer refresh flag; a second AND logic circuit 304, where a first input terminal is connected to the output terminal of the first AND logic circuit 302, a second input terminal is configured to receive a row hammer refresh window, and an output terminal is configured to output a second refresh window; and a third AND logic circuit 305, where a first input terminal is connected to the output terminal of the inverter 303, a second input terminal is configured to receive the row hammer refresh window, and an output terminal is configured to output a first refresh window.

It should be noted that the first AND logic circuit 302, the second AND logic circuit 304, and the third AND logic circuit 305 provided in FIG. 6 may be implemented based on AND gates, or implemented based on AND gate cascaded inverters, or implemented by a combination of other gate circuits.

In some embodiments, referring to FIG. 1, the memory block 20 controls, through the refresh control circuit 103, refresh of the supplementary refresh address or refresh of the row hammer refresh address, where the refresh control circuit 103 includes a row hammer refresh circuit and a supplementary refresh circuit, where the row hammer refresh circuit is configured to perform refresh of the row hammer address based on the first refresh window and the row hammer refresh flag; and the supplementary refresh circuit is configured to perform refresh of the supplementary refresh address based on the second refresh window and the supplementary refresh flag.

In some embodiments, the counter is formed based on cascaded D flip-flops, and output of the determination value may be implemented by a combinational circuit formed by output terminals of corresponding D flip-flops and a gate circuit. For example, if determination values are 2 and 5, the determination value 2 may be implemented by output data of a second stage D flip-flop, and the determination value 5 may be implemented by connecting an AND gate to a first stage D flip-flop and a third stage D flip-flop.

The memory structure according to this embodiment extends row hammer protection of a memory to perform row hammer protection and refresh of the supplementary refresh address during original row hammer protection. Specifically, in the original row hammer protection, refresh of the row hammer refresh address is performed based on the row hammer refresh windows, and after row hammer protection is extended, the row hammer refresh windows are subdivided into the first refresh window and the second refresh window, where the first refresh window is continuously used for row hammer protection, that is, for performing refresh of the row hammer refresh address, and the second refresh window is used for refresh of the supplementary refresh address, such that the memory can better store data stored in the weak cells, and negative effects brought by repair of the weak cells are avoided.

It should be noted that the features disclosed in the memory structure according to the above embodiments can be combined arbitrarily without conflict, and a new memory structure embodiment can be obtained.

Another embodiment of the present disclosure provides a refresh method, which provides a refresh manner related to weak cells, to avoid negative effects brought by repair of the weak cells.

The following describes the refresh method according to this embodiment in detail with reference to the accompanying drawings. Details are as follows:
Referring to FIG. 7, which is a schematic flowchart of a refresh method according to another embodiment of the present disclosure, the refresh method includes steps 401 to 404.

At step 401, supplementary refresh addresses are recorded in a memory controller.

Specifically, the supplementary refresh addresses stored in a refresh address storing circuit are acquired by a memory in a test stage.

In some embodiments, the refresh address storing circuit is disposed based on an antifuse memory array. Specifically, the memory fuses a corresponding memory cell in the antifuse memory array based on an address of the weak memory cell acquired in the test stage, such that the refresh address storing circuit 101 stores the supplementary refresh address; the refresh address storing circuit disposed based on the antifuse memory array can retain the set supplementary refresh address in a relatively complete manner even if the power of the memory structure is down. In other embodiments, the refresh address storing circuit may also store the supplementary refresh address based on a register or based on capacitive storage.

At step 402, the memory controller transmits the set supplementary refresh addresses to corresponding memory blocks.

Specifically, the memory controller transmits the set supplementary refresh address to the corresponding memory block.

In some embodiments, the refresh address storing circuit transmits the supplementary refresh address to the corresponding refresh register in a broadcast manner. Specifically, in the power-on process of the memory, the refresh address storing circuit correspondingly transmits the stored supplementary refresh address to the refresh register of the corresponding memory block in a broadcast manner, to increase a delivering speed of the supplementary refresh address. In other embodiments, the refresh address storing circuit may also be configured to correspondingly transmit the supplementary refresh address to the refresh register of the corresponding memory block based on a corresponding control signal in the power-on process of the memory structure.

At step 403, a first refresh window and a row hammer refresh flag are acquired, or a second refresh window and a supplementary refresh flag are acquired.

The first refresh window and the second refresh window are allocated based on row hammer refresh windows, and a proportion of the first refresh window to the second refresh window is a first preset value.

In some embodiments, step 403 specifically includes: acquiring an identification signal and determining whether the identification signal is valid or not.

If the identification signal is invalid, the first refresh window is generated based on the row hammer refresh window, and the row hammer refresh flag is generated based on the row hammer refresh signal. If the identification signal is valid, cycle count is performed based on the row hammer refresh signal to generate a determination value, where when the determination value is valid, the second refresh window is generated based on the row hammer refresh window, and the supplementary refresh flag is generated based on the row hammer refresh signal; and when the determination value is invalid, the first refresh window is generated based on the row hammer refresh window, and the row hammer refresh flag is generated based on the row hammer refresh signal, where the determination value is used to configure the first preset value.

Specifically, because the identification signal represents the start time of a supplementary refresh address, only when the identification signal is valid, a memory structure allocates the row hammer refresh windows to implement the refresh of the supplementary refresh address. In one example, the identification signal is valid when the identification signal is at a high level and is invalid when the identification signal is at a low level. In another example, it may also be configured that the identification signal is valid when the identification signal is at a low level and is invalid when the identification signal is at a high level.

For performing cycle count based on the row hammer refresh signal to generate the determination value, the principle that the determination value is used to configure the first preset value is as follows: Assuming that a row hammer refresh signal cycle count value is a1, that is, count of +1 starts from 0 based on each row hammer refresh signal, upon count to a1, reset is performed to restart the count, and when the count value meets a2, a3, ..., and ai, a valid determination value is generated. In this case, in a1 values, determination values generated by using a1-i values are invalid, and determination values generated by using i values are valid, that is, the first preset value is a1-i:i. In one example, the determination value is valid when the determination value is at a high level and is invalid when the determination value is at a low level. In another example, it may also be configured that the determination value is valid when the determination value is at a low level and is invalid when the determination value is at a high level.

In a specific example, the cycle count value is 5, when the count value meets 2 and 3, a valid determination value is generated. In this case, determination values generated by using three values are invalid, determination values generated by using two values are valid, and the first preset value is 3:2. In addition, refresh of the row hammer address and the supplementary refresh address is cyclically performed in an order of "row hammer-supplementary-supplementary-row hammer-row hammer".

In some embodiments, a method of acquiring the identification signal includes: performing count based on each refresh command to generate a refresh count value; and generating and outputting the identification signal when the refresh count value meets a second preset value.

A time period for performing refresh of the supplementary refresh address during refresh-all-bank operation of the memory is set depending on whether the refresh count value meets the second preset value. In one example, refresh of the supplementary refresh address is performed in the initial phase of the refresh-all-bank operation. In this case, the second preset value is set to be equal to or less than k, where k is a product of a capacity of a corresponding refresh register 102 for storing the supplementary refresh address and the first preset value. For example, the capacity of the refresh register 102 for storing the supplementary refresh address is 80, and the first preset value is used to represent that one second refresh window is used to refresh the supplementary refresh address in every three row hammer refresh windows. In this case, 240 row hammer refresh windows are required to complete the refresh of all the supplementary refresh addresses, and two refresh commands in the memory in this embodiment correspond to one row hammer refresh window, that is, k is set to 240 × 2 = 480. In another example, refresh of the supplementary refresh address is performed in the intermediate phase of the refresh-all-banks operation. In yet another example, the refresh of the supplementary refresh address is performed at the end phase of the refresh-all-bank operation.

At step 404, during row hammer refresh, refresh of the row hammer address is performed based on the first refresh window and the row hammer refresh flag, or refresh of the supplementary refresh address is performed based on the second refresh window and the supplementary refresh flag.

It should be noted that the features disclosed in the refresh method according to the above embodiments can be combined arbitrarily without conflict, and a new refresh method embodiment can be obtained. In addition, this embodiment can be implemented in cooperation with the refresh control structure according to the previous embodiment. The related technical details mentioned in the previous embodiment are still valid in this embodiment, and are not described herein again in order to reduce repetition.

FIG. 8 is a schematic structural diagram of a memory according to yet another embodiment of the present disclosure. Referring to FIG. 8, yet another embodiment of the present disclosure provides a memory 1, and the memory is disposed based on the memory structure 2 according to the above embodiment, to avoid negative effects brought by repair of weak cells.

Specifically, row hammer protection of the memory 1 is extended to perform row hammer protection and refresh of a supplementary refresh address during original row hammer protection.

Specifically, in the original row hammer protection, refresh of a row hammer refresh address is performed based on a row hammer refresh window, and after row hammer protection is extended, the row hammer refresh windows are subdivided into a first refresh window and a second refresh window, where the first refresh window is continuously used for row hammer protection, that is, for performing refresh of the row hammer refresh address, and the second refresh window is used for refresh of the supplementary refresh address, such that the memory 1 can better store data stored in the weak cells, and negative effects brought by repair of the weak cells are avoided.

The memory 1 may be a memory cell or apparatus based on semiconductor apparatuses or components. For example, the memory apparatus may be a volatile memory, such as a dynamic random access memory DRAM, a synchronous dynamic random access memory SDRAM, a double data rate synchronous dynamic random access memory DDR SDRAM, a low-power double data rate synchronous dynamic random access memory LPDDR SDRAM, a graphics double data rate synchronous dynamic random access memory GDDR SDRAM, a double data rate 2 synchronous dynamic random access memory DDR2 SDRAM, a double data rate 3 synchronous dynamic random access memory DDR3 SDRAM, a double data rate 4 synchronous dynamic random access memory DDR4 SDRAM, a thyristor random access memory TRAM, or the like; or the memory apparatus may be a non-volatile memory, such as a phase change random access memory PRAM, a magnetic random access memory MRAM, a resistive random access memory RRAM, or the like.

Those of ordinary skill in the art can understand that the above embodiments are specific embodiments of practicing the present disclosure, while in practical application, various changes can be made to the implementations in form and detail without departing from the spirit and scope of the present disclosure.

## Claims

1. A memory structure, the memory structure comprising a memory controller (10) and a plurality of memory blocks (20), and the memory structure comprising:
a refresh address storing circuit (101), disposed in the memory controller (10) and configured to store supplementary refresh addresses, each of the supplementary refresh addresses being used to indicate a memory cell with a defective capability for storing electric charges; and
refresh registers (102), each of the refresh registers (102) being disposed in each memory block (20) of the plurality of memory blocks (20);
wherein in a power-on process of the memory structure, the refresh address storing circuit (101) transmits the supplementary refresh address to the corresponding refresh register (102); and
each memory block (20) is configured to: during row hammer refresh, perform refresh of a row hammer address based on a first refresh window and a row hammer refresh flag, or perform refresh of the supplementary refresh address based on a second refresh window and a supplementary refresh flag;
wherein the first refresh window and the second refresh window are allocated based on row hammer refresh windows, and a proportion of the first refresh window to the second refresh window is a first preset value.

2. The memory structure according to claim 1, wherein the memory controller (10) comprises:
a first refresh control circuit (201), configured to generate an identification signal;
a second refresh control circuit (202), configured to generate the row hammer refresh windows and a row hammer refresh signal; and
a refresh processing circuit (203), connecting the first refresh control circuit (201) and the second refresh control circuit (202), wherein
if the identification signal is invalid, the refresh processing circuit (203) is configured to generate the first refresh window based on the row hammer refresh windows, and generate the row hammer refresh flag based on the row hammer refresh signal;
if the identification signal is valid, the refresh processing circuit (203) is configured to perform cycle count based on the row hammer refresh signal to generate a determination value, wherein when the determination value is valid, the refresh processing circuit (203) is further configured to generate the second refresh window based on the row hammer refresh windows, and generate the supplementary refresh flag based on the row hammer refresh signal; and when the determination value is invalid, the refresh processing circuit (203) is further configured to generate the first refresh window based on the row hammer refresh windows, and generate the row hammer refresh flag based on the row hammer refresh signal; and
the determination value is used to configure the first preset value.

3. The memory structure according to claim 2, wherein the first refresh control circuit (201) comprises:
a count processing circuit, configured to perform count based on each refresh command to generate a refresh count value, wherein
the count processing circuit is further configured to generate and output the identification signal when the refresh count value meets a second preset value; and
the second preset value is set to be less than or equal to k, wherein k is a product of a capacity of the corresponding refresh register (102) for storing the supplementary refresh address and the first preset value.

4. A memory structure according to claim 2, wherein the refresh processing circuit (203) comprises:
a counter (301), configured to generate the determination value;
a first AND logic circuit (302), wherein a first input terminal is connected to an output terminal of the counter (301), a second input terminal is configured to receive the row hammer refresh signal, and an output terminal is configured to output the supplementary refresh flag;
an inverter (303), wherein an input terminal is connected to the output terminal of the first AND logic circuit (302), and an output terminal is configured to output the row hammer refresh flag;
a second AND logic circuit (304), wherein a first input terminal is connected to the output terminal of the first AND logic circuit (302), a second input terminal is configured to receive the row hammer refresh windows, and an output terminal is configured to output the second refresh windows; and
a third AND logic circuit (305), wherein a first input terminal is connected to the output terminal of the inverter (303), a second input terminal is configured to receive the row hammer refresh windows, and an output terminal is configured to output the first refresh window.

5. The memory structure according to claim 2, wherein each memory block (20) comprises:
a row hammer refresh circuit, configured to perform refresh of the row hammer address based on the first refresh window and the row hammer refresh flag; and
a supplementary refresh circuit, configured to perform refresh of the supplementary refresh address based on the second refresh window and the supplementary refresh flag.

6. The memory structure according to claim 1, wherein operations of performing refresh of the row hammer address and performing refresh of the supplementary refresh address are cyclically performed in a preset order.

7. The memory structure according to claim 1, wherein the refresh address storing circuit (101) is disposed based on an antifuse memory array.

8. The memory structure according to claim 1, wherein the refresh address storing circuit (101) transmits the supplementary refresh address to the corresponding refresh register (102) in a broadcast manner.

9. A refresh method, applied to the memory structure according to any one of claims 1 to 8, comprising:
(401:) recording the supplementary refresh addresses in the memory controller (10);
(402:) transmitting, by the memory controller (10), the set supplementary refresh addresses to the corresponding memory blocks (20);
(403:) acquiring the first refresh window and the row hammer refresh flag, or acquiring the second refresh window and the supplementary refresh flag; and
(404:) during row hammer refresh, performing refresh of the row hammer address based on the first refresh window and the row hammer refresh flag, or performing refresh of the supplementary refresh address based on the second refresh window and the supplementary refresh flag,
wherein the first refresh window and the second refresh window are allocated based on the row hammer refresh windows, and the proportion of the first refresh window to the second refresh window is the first preset value.

10. The refresh method according to claim 9, wherein the memory controller (10) further comprises the first refresh control circuit (201) and the second refresh control circuit (202), the first refresh control circuit (201) being configured to generate the identification signal, and the second refresh control circuit (202) being configured to generate the row hammer refresh windows and the row hammer refresh signal, and acquiring the first refresh window and the row hammer refresh flag, or acquiring the second refresh window and the supplementary refresh flag comprises:
acquiring the identification signal;
if the identification signal is invalid, generating the first refresh window based on the row hammer refresh windows, and generating the row hammer refresh flag based on the row hammer refresh signal; and
if the identification signal is invalid, performing cycle count based on the row hammer refresh signal to generate a determination value, wherein when the determination value is valid, the second refresh window is generated based on the row hammer refresh windows, and the supplementary refresh flag is generated based on the row hammer refresh signal; and when the determination value is invalid, the first refresh window is generated based on the row hammer refresh windows, and the row hammer refresh flag is generated based on the row hammer refresh signal.

11. The refresh method according to claim 10, wherein a method of acquiring the identification signal comprises:
performing count based on each refresh command to generate a refresh count value; and
generating and outputting the identification signal when the refresh count value meets the second preset value; wherein
the second preset value is set to be less than or equal to k, wherein k is the product of the capacity of the corresponding refresh register for storing the supplementary refresh address and the first preset value.

12. A memory (1), the memory being disposed based on the memory structure (2) according to any one of claims 1 to 8.
